# EUROPEAN PATENT APPLICATION

(11) **EP 4 807 791 A1**
(43) Date of publication of application: **16.09.2026**
(21) Application number: 25181221.0
(22) Date of filing: 06.06.2025
(51) Int. Cl.: H01L 23/40, H01L 21/48, H05K 1/02

(54) **HEAT DISSIPATION MODULE, ASSEMBLING METHOD THEREOF AND ELECTRONIC DEVICE HAVING THE SAME**

(30) Priority: 10.03.2025 CN 202510276192
(71) Applicant: DELTA ELECTRONICS, INC., Taoyuan City 320023 (TW)
(72) Inventor: YANG, Shan-Chun, 320023 Taoyuan City (TW); HSU, Chung-Wen, 320023 Taoyuan City (TW); WU, Kuan-Lung, 320023 Taoyuan City (TW); CHIU, Shao-Li, 320023 Taoyuan City (TW); HSIEH, Chen-Yang, 320023 Taoyuan City (TW)
(74) Representative: 2K Patent Partnerschaft mbB

(57) **Abstract**

This disclosure is directed to a heat dissipation module, an assembling method thereof and an electronic device having the same. The heat dissipation module is used for dissipating heat from a heat source (110) on a circuit board (100), the heat dissipation module has a fixing seat (200), a combination frame (300) and a heat dissipator (400). The fixing seat (200) is arranged on the circuit board (100) to locate the heat source (110) at or adjacent to a center of the fixing seat (200). The fixing seat (200) has a plurality of first latches (210). The combination frame (300) has a limiting structure (310) and a plurality of second latches (320). The second latches (320) are respectively snapped on the first latches (210) to fix the combination frame (300) on the fixing seat (200). The limiting structure (310) limits the heat dissipator (400) so that at least a portion of the heat dissipator (400) is limited in the combination frame (300) to attach the heat dissipator (400) to the heat source (110) along a vertical direction. Accordingly, the heat dissipator (400) may be quickly, stably and accurately installed on the circuit board (100) and sealed with the heat source (110). Moreover, the heat dissipator (400) is avoided from deformation caused by overload or uneven load during an installation process.

## Description

### BACKGROUND OF THE DISCLOSURE

### Technical Field

This disclosure is related to heat dissipation, in particular to a heat dissipation module, an assembling method thereof and an electronic device having the same.

### Description of Related Art

Since science and technology are rapidly developed, various electronic devices are gradually developed to be more compact and efficient, and it may be operated with a great amount of heat generation. Accordingly, some electronic devices are provided with a heat dissipator to cool the heat sources therein, thereby ensuring working efficiency and operation life by maintaining an operating temperature within an appropriate range.

However, a heat dissipators of related art is fastened on a circuit board or a housing with four screws penetrating through four corners of the heat dissipator. Therefore, each screw should be slowly twisted alternately in sequence when fastening so as to avoid uneven pressure which may lead to a damage to the heat source caused by a pressure from the heat dissipator. When fastening the screws, it is also necessary to pay attention to prevent the heat dissipator from shifting relative to the heat source. In addition, a deformation caused by uneven stress may occur on the heat dissipator which is fastened by the screws, so that a protrusion may be formed at middle thereof. Accordingly, sealing and heat transfer efficiency between the heat dissipator and the heat source may be affected.

In views of this, in order to solve the above disadvantage, the inventor studied related technology and provided a reasonable and effective solution in this disclosure.

### SUMMARY OF THE INVENTION

A main purpose of this disclosure is to install the dissipator to the heat source quickly, stably and accurately and seal the dissipator with a heat source, and to prevent the heat dissipator from deformation caused by overload or uneven load during an installation process.

In order to achieve the aforementioned purpose, this disclosure is directed to a heat dissipation module, for cooling a heat source on a circuit board. The heat dissipation module has a fixing seat a combination frame and a heat dissipator. The fixing seat is arranged on the circuit board to locate the heat source at or adjacent to a center of the fixing seat, the fixing seat has a plurality of first latches. The combination frame has a limiting structure and a plurality of second latches; the second latches are snapped on the first latches respectively to fix the combination frame on the fixing seat. The heat dissipator is limited by the limiting structure, at least a portion of the heat dissipator is limited in the combination frame so that the heat dissipator is attached to the heat source along a vertical direction.

In one embodiment of this disclosure, the limiting structure has a plurality of third latches, the third latches are snapped on the heat dissipator to gather so that the heat dissipator is limited by the combination frame along the vertical direction.

In one embodiment of this disclosure, the combination frame is rectangular and hollow and disposed to surround the heat source, the heat dissipator is arranged in the combination frame so that the heat dissipator is limited by the combination frame along a longitudinal direction and a lateral direction the longitudinal direction, the lateral direction and the vertical direction are perpendicular to each other.

In one embodiment of this disclosure, the combination frame has a positioning hole, the fixing seat has a positioning pin, the positioning hole sheathes the positioning pin to position the combination frame on the fixing seat.

In one embodiment of this disclosure, the heat dissipation module further has a fastening assembly, the fastening assembly has a pressing plate and a plurality of spring bolts, the pressing plate has a pressing portion and a pair of connecting portions respectively connected to two opposite end of the pressing portion, the fixing seat has a plurality of studs, the spring bolts respectively penetrating through the connecting portions to respectively fasten the studs so that the heat dissipator is pressed by the pressing portion to attach on the heat source.

In order to achieve the aforementioned purpose, this disclosure is directed to an assembling method of a heat dissipation module having a pre-assembling step, a first assembling step and a second assembling step. The pre-assembling step (a) has provided a circuit board and a fixing seat, the circuit board having a heat source, the fixing seat having a plurality of first latches, arranging the fixing seat on the circuit board to locate the heat source at or adjacent to a center of the fixing seat. The first assembling step has provided a combination frame and a heat dissipator, the combination frame having a limiting structure and a plurality of second latches, assembling the combination frame with one of the fixing seat and the heat dissipator into a semi-assembly. The second assembling step has assembling another of the fixing seat and the heat dissipator with the semi-assembly, respectively snapping the second latches on the first latches to fix the combination frame on the fixing seat, and meanwhile limiting at least a portion of the heat dissipator by the limiting structure to attach the heat dissipator on the heat source.

In one embodiment of this disclosure, the assembling method further having a fixing step (e), the fixing step (e) having providing a pressing plate and a plurality of spring bolts, the pressing plate having a pressing portion and a pair of connecting portions respectively connected to two opposite ends of the pressing portion, respectively penetrating the spring bolts to the connecting portions to fasten to the fixing seat so that the heat dissipator is pressed by the pressing portion to attach on the heat source.

In order to achieve the aforementioned purpose, this disclosure is directed to an electronic device having a housing, a circuit board, a fixing seat, a combination frame and a heat dissipator. The circuit board is arranged in the housing, the circuit board has a heat source. The fixing seat is arranged on the circuit board to locate the heat source at or adjacent to a center of the fixing seat, the fixing seat has a first latch; a combination frame and has a limiting structure and a plurality of second latches, and the second latches are respectively snapping the second latches on the first latches to fix the combination frame on the fixing seat. The heat dissipator is limited by the limiting structure, at least a portion of the heat dissipator is limited in the combination frame so that the heat dissipator is attached to the heat source along a vertical direction.

In one embodiment of this disclosure, the limiting structure has a plurality of third latches, the third latches are snapped on the heat dissipator to gather so that the heat dissipator is limited by the combination frame along the vertical direction.

In one embodiment of this disclosure, the combination frame is rectangular and hollow and disposed to surround the heat source, the heat dissipator is arranged in the combination frame so that the heat dissipator is limited by the combination frame along a longitudinal direction and a lateral direction, the longitudinal direction, the lateral direction and the vertical direction are perpendicular to each other.

In one embodiment of this disclosure, the combination frame has a positioning hole, the fixing seat has a positioning pin, the positioning hole sheathes the positioning pin to position the combination frame on the fixing seat.

In one embodiment of this disclosure, the heat dissipation module further has a fastening assembly, the fastening assembly has a pressing plate and a plurality of spring bolts, the pressing plate has a pressing portion and a pair of connecting portions respectively connected to two opposite ends of the pressing portion. The fixing seat has a plurality of studs, the spring bolts are respectively penetrating through the connecting portions to respectively fasten the studs so that the heat dissipator is pressed by the pressing portion to attach on the heat source.

The heat dissipator may be limited by the limiting structure of the combination frame, and fixed by a connection of respectively snapping the second latches of the combination frame on the first latches of the fixing seat. Accordingly, the heat dissipator may be quickly, stably and accurately attached to the heat source along the vertical direction D1. Moreover, the heat dissipator is avoided from deformation caused by overload or uneven load during an installation process.

### BRIEF DESCRIPTION OF THE DRAWINGS

FIG. 1 is an exploded view of the heat dissipation module according to this disclosure.
FIG. 2 is a perspective view showing the heat dissipation module according to this disclosure.
FIG. 3 is a cross-sectional view at a side of the heat dissipation module according to this disclosure.
FIG. 4 is another cross-sectional view at another side of the heat dissipation module according to this disclosure.
FIG. 5 is a cross-sectional normal view of the heat dissipation module according to this disclosure.
FIG. 6 is a flow chart of steps of the assembling method of the heat dissipation module according to this disclosure.
FIG. 7 is a top view showing a portion of the electronic device according to this disclosure.

### DETAILED DESCRIPTION

The technical contents of this disclosure will become apparent with the detailed description of embodiments accompanied with the illustration of related drawings as follows. It is intended that the embodiments and drawings disclosed herein are to be considered illustrative rather than restrictive.

It should be understood that the orientations or positional relationships in this disclosure which are indicated by the terms such as "front side", "rear side", "left side", "right side", "front end", "rear end", "end", "vertical", "horizontal", "top" and "bottom" are based on the orientations or positional relationships as shown in the drawings. These are only used for describing this disclosure and simplifying the description rather than indicating or implying that the device or element have a specific orientation or be constructed and operated in a specific orientation, and it should not be considered as limitations of the scopes of this disclosure.

The terms used herein without additional definition such as "substantially" and "approximately" are used to describe and illustrate small changes. When used in an event or situation, the term may include the precise moment at which the event or situation occurs, and a close approximation to moment the event or situation occurs. For example, when combined with a numerical value, the term may include a range of variation less than or equal to ±10% of the numerical value, such as less than or equal to ±5%, less than or equal to ±4%, less than or equal to ±3%, less than or equal to ±2%, less than or equal to ±1%, less than or equal to ±0.5%, less than or equal to ±0.1%, or less than or equal to ±0.05%.

Detailed descriptions and technical contents of this disclosure is described in the flowing paragraph with reference to the drawings. However, the drawings are attached only for illustration and are not intended to limit this disclosure.

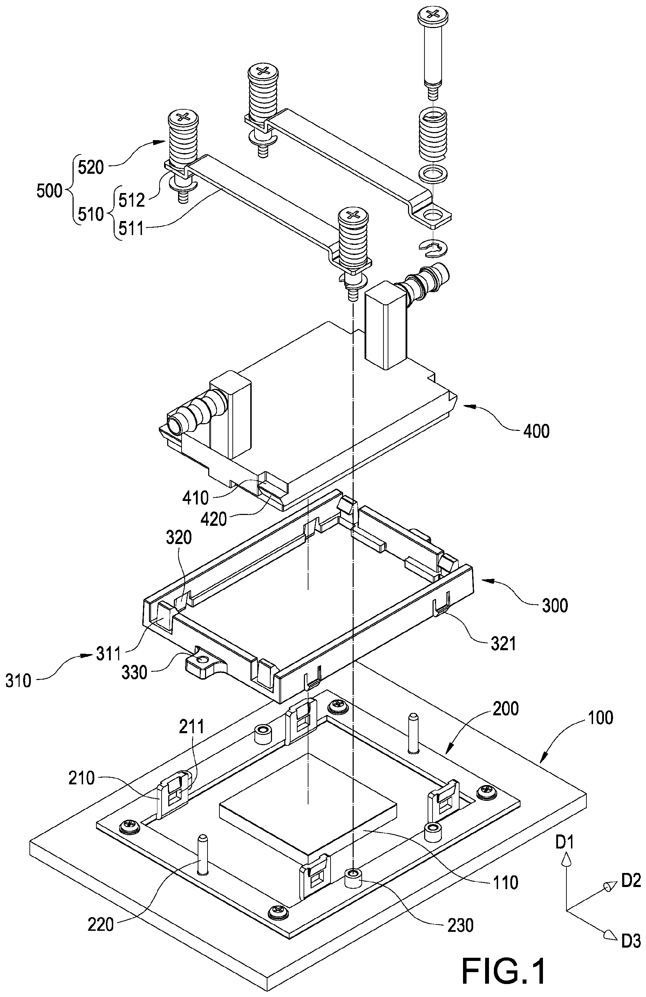

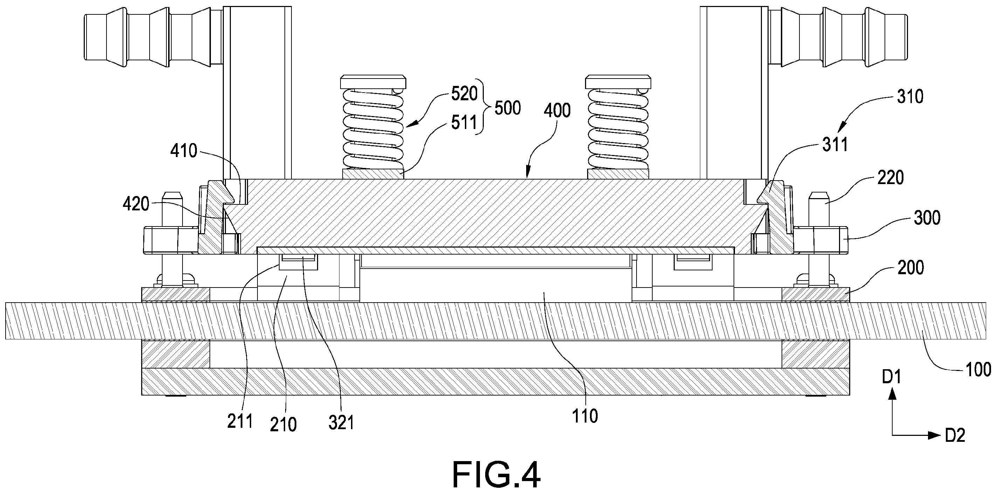

This disclosure is directed to a heat dissipation module used for cooling a heat source 110 (e.g. a chip) on a circuit board 100. Referring to FIGS. 1 to 5 firstly, the heat dissipation module according to this disclosure has a fixing seat 200, a combination frame 300 and a heat dissipator 400. According to this embodiment, the heat dissipator 400 is a liquid cooling head made of heat conductive metal(s) such as copper and aluminum and operated with a coolant, but the scopes of this disclosure should not be limited to the embodiments. For example, the heat dissipator 400 may be a heat sink.

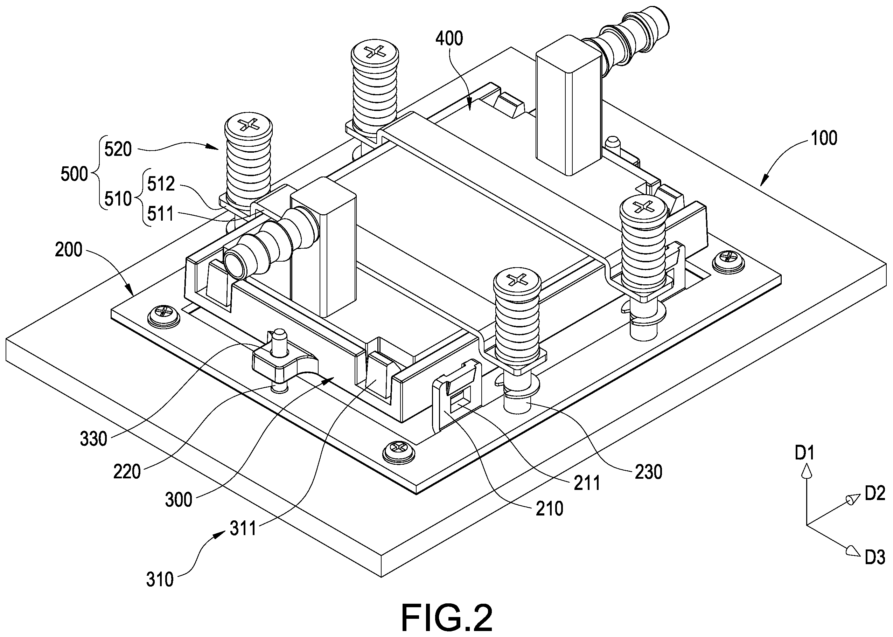

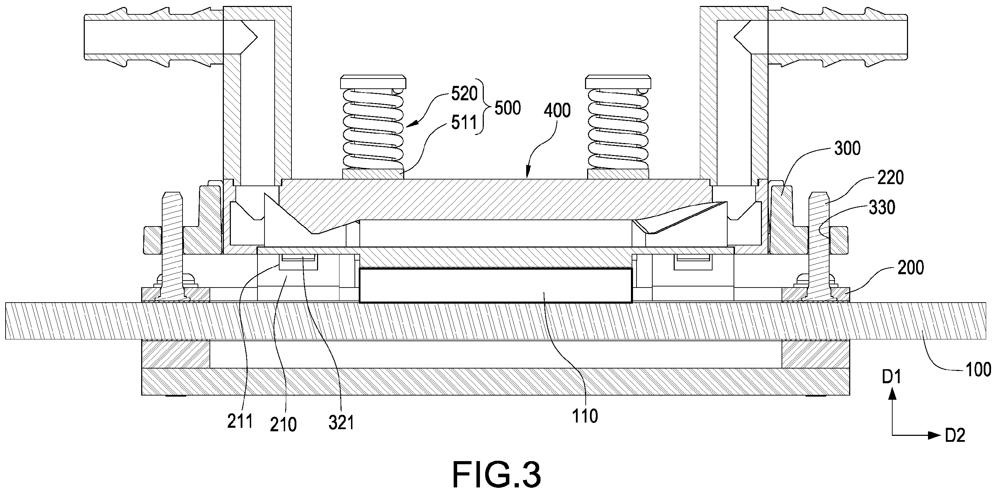

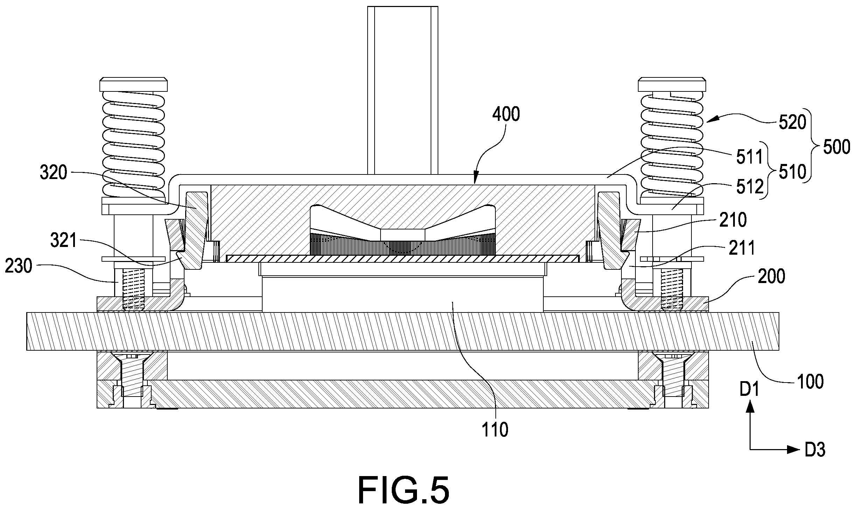

According to this embodiment, the fixing seat 200 is made of metal to ensure a structure strength of the heat dissipation module, but the scopes of this disclosure should not be limited to the embodiments. The fixing seat 200 is arranged on the circuit board 100 to locate the heat source 110 at or adjacent to a center of the fixing seat 200. Specifically, the fixing seat 200 of this embodiment is a hollow rectangular plate, and the heat source 110 is enclosed therein, but the scopes of this disclosure should not be limited to the embodiments. For example, the fixing seat 200 may be multiple blocks or plates which are rectangular, curved or L-shaped, and may surround the heat source 110 at or adjacent to the center. Moreover, the fixing seat 200 according to this embodiment has a plurality of screws (the elements without marked with numeral as shown in FIGS. 1 and 2) penetrating the fixing seat 200 and the circuit board 100 in sequence and further screwing to at least one clamper (the elements without marked with numeral as shown in FIGS. 3 and 5), so that the fixing seat 200 is firmly fixed on the circuit board 100. Specifically, the clamper may be a metal seat with multiple screw holes or may be a nut, but the scopes of this disclosure should not be limited to the embodiments. The fixing seat 200 has a plurality of first latch 210. Each of the first latches 210 is extended from the fixing seat 200, away from the circuit board 100 and along a vertical direction D1 namely an upward or a downward direction as shown in figures.

According to this embodiment, the combination frame 300 is a one-piece plastic part made by injection molding, so that the combination frame 300 is formed as an elastically deformable structure with a required shape, but the scopes of this disclosure should not be limited to the embodiment. The combination frame 300 has a limiting structure 310 and multiple second latches 320. Each of the second latches 320 is extended from the combination frame 300 toward the fixing seat 200 and the circuit board 100. The second latches 320 are respectively snapped on the first latches 210, so as to fix the combination frame 300 on the fixing seat 200. Specifically, according to this embodiment, each of the second latches 320 has a barb 321 at an end thereof, each first latch 210 has a snapping hole 211, so that the barb 321 may be snapped into the snapping hole 211 to perform a snap connection, but the scopes of this disclosure should not be limited to the embodiments. For example, the barb 321 may be arranged on the first latch 210 and the snapping hole 211 may be arranged on the second latch 320, or each of the first latches 210 and the second latches 320 is provided with a barb 321. The heat dissipator 400 is limited by the limiting structure 310, so that at least a portion of the heat dissipator 400 is limited in the combination frame 300. Therefore, the heat dissipator 400 may be limited by the limiting structure 310 of the combination frame 300, and fixed by a connection of respectively snapping the second latches 320 of the combination frame 300 on the first latches 210 of the fixing seat 200. Accordingly, the heat dissipator 400 may be quickly, stably and accurately attached to the heat source 110 along the vertical direction D1. Moreover, the heat dissipator 400 is avoided from deformation caused by overload or uneven load during an installation process.

Furthermore, the combination frame 300 according to this embodiment is a hollow rectangular frame, and the limiting structure 310 of the combination frame 300 has multiple third latches 311 extended therefrom along the vertical direction D1, the third latch 311 are snapped on the heat dissipator 400 together to limit the heat dissipator 400 by the combination frame 300 along the vertical direction D1, but the scopes of this disclosure should not be limited to the embodiment. For example, the combination frame 300 may be a hollow rectangular plate with a recess at a bottom thereof for covering a periphery on a top of the heat dissipator 400, thereby limiting the heat dissipator 400 as well. According to this embodiment, the heat dissipator 400 has multiple snapping notches 410 at four corners on a top thereof, the third latches 311 are respectively snapped on the snapping notches 410, so as to avoid interference caused by the third latches 311 protruding from the heat dissipator 400. Furthermore, the heat dissipator 400 according to this embodiment also has multiple guiding slopes 420 respectively disposed corresponding to the snapping notches 410, the guiding slopes 420 are respectively disposed at four corners on a bottom of the heat dissipator 400, thereby guiding the third latches 311 to avoid deformation in assembling.

According to this embodiment, the combination frame 300 is rectangular and hollow, and disposed to surround the heat source 110. The heat dissipator 400 is arranged in the combination frame 300, thereby limiting the periphery of the heat dissipator 400 along a longitudinal direction D2 (namely directions forward or backward as shown in figures) and a lateral direction D3(namely directions leftward or rightward as shown in figures) by the combination frame 300. The longitudinal direction D2, the lateral direction D3 and the vertical direction D1 are substantially perpendicular to each other. In other words, the combination frame 300 with a hollow rectangular shape may limits the periphery of the heat dissipator 400, and the third latches 311 are snapped on the heat dissipator 400, so that the heat dissipator 400 may be completely limited. In addition, since the combination frame 300 is snapped into the first latches 210 of the fixing seat 200 via the second latches 320, the heat dissipator 400 may be effectively fixed on the circuit board 100 and prevented from deformation caused by overload.

Furthermore, two positioning holes 330 and two positioning pins 220 are provided, the positioning holes 330 are arranged opposite to each other at two opposite sides of the combination frame 300, and the positioning pins 220 are arranged opposite to each other at two opposite sides of the fixing seat 200, but the scopes of this disclosure should not be limited to the embodiment. The positioning holes 330 of the combination frame 300 respectively sleeve the positioning pins 220 of the fixing seat 200, so as to position the combination frame 300 on the fixing seat 200. **It** is worth to be mentioned that, the positioning pins 220 and the positioning holes 330 are installed and made accurately, and the combination frame 300 may therefore be effectively positioned at a predetermined position of the fixing seat 200, so that the heat dissipator 400 is sealed with the heat source 110. Furthermore, the fixing seat 200 and the heat dissipator 400 of this embodiment are both made of metal, and the combination frame 300 is made of plastic, so that the combination frame 300 has a structural strength lower than that of the fixing seat 200 and the heat dissipator 400, and the combination frame 300 is therefore elastically deformable. When the combination frame 300 is snapped to the first latches 210 of the fixing seat 200 through the second latches 320, a slight elastic deformation may be caused on the combination frame 300 to eliminate dimensional tolerances between the heat dissipator 400, the combination frame 300, and the fixing seat 200, so that the combination frame 300 may be accurately fixed on the fixing seat 200 together with the heat dissipator 400.

In order to further ensure the stability of the heat dissipator 400, the heat dissipation module of this disclosure further has a fastening assembly 500. The fastening assembly 500 has at least one pressing plate 510 and multiple spring bolts 520. **In** this embodiment, two the pressing plates 510 and four the spring bolts 520 are provided, but the scopes of this disclosure should not be limited to the embodiment. For example, only one pressing plate 510 or more than three pressing plates 510 may be provided, and a specific quantity of the spring bolt(s) 520 may be provided corresponding to quantity and form of the pressing plate(s) 510. Each of the pressing plates 510 has a pressing portion 511 and a pair of connecting portions 512 respectively connected to two opposite ends of the pressing portion 511. Specifically, each pressing portion 511 is a plate which is able to attach on a top of the heat dissipator 400, the connecting portions 512 are respectively connected to the two opposite ends of the pressing portion 511 and therefore located at two opposite sides of the heat dissipator 400. The spring bolts 520 are respectively inserted in the connecting portions 512 and screwed to the fixing seat 200, so that the heat dissipator 400 is pressed by the pressing portion 511 to attach on the heat source 110. According to this embodiment, the fixing seat 200 has multiple studs 230, the spring bolts 520 are respectively inserted through the connecting portions 512 and further screwed with the studs 230, but the scopes of this disclosure should not be limited to the embodiment. Accordingly, the spring bolts 520 are respectively inserted through the connecting portions 512 and then screwed with the fixing seat 200, so that the heat dissipator 400 may be pressed by the pressing portions 511 of the pressing plate 510 to be sealed with the heat source 110 and the heat dissipator 400 may be pressed and firmly fixed to prevent the heat dissipator 400 from deformation caused by overloading or uneven loading.

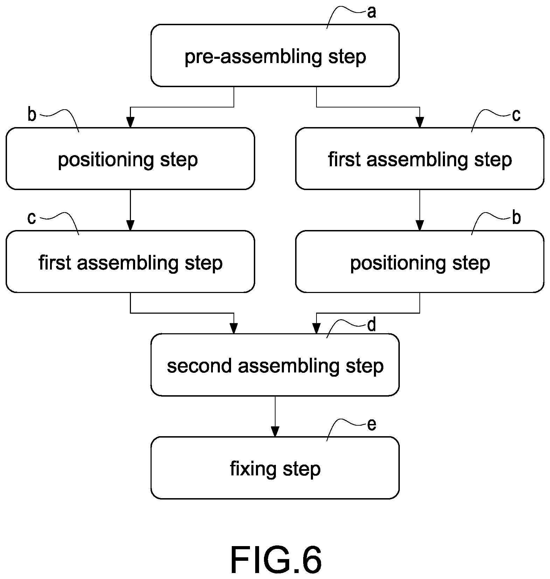

Further, referring to FIG. 6 with FIGS. 1 to 5, this disclosure provides an assembling method of a heat dissipation module, which has a pre-assembling step (a), a first assembling step (c) and a second assembling step (d).

In the pre-assembling step (a), a circuit board 100 and a fixing seat 200 are provided. The circuit board 100 has a heat source 110, the fixing seat 200 has multiple first latches 210. Arranging the fixing seat 200 on the circuit board 100, so that the heat source 110 is located at or adjacent to a center of the fixing seat 200.

In the first assembling step (c), a combination frame 300 and a heat dissipator 400 are provided. The combination frame 300 has a limiting structure 310 and multiple second latches 320. The combination frame 300 is assembled with one of the fixing seat 200 and the heat dissipator 400 to form a semi-assembly (as shown in figures without mark number).

In the second assembling step (d), another one of the fixing seat 200 and the heat dissipator 400 is assembled with the semi-assembly, so that the second latches 320 are respectively snapped on the first latches 210 to fix the combination frame 300 on the fixing seat 200, and at least a portion of the heat dissipator 400 is therefore limited by the limiting structure 310 to attach the heat dissipator 400 on the heat source 110.

Therefore, the heat dissipator 400 may be limited by the limiting structure 310 of the combination frame 300, and fixed by a connection of respectively snapping the second latches 320 of the combination frame 300 on the first latches 210 of the fixing seat 200. Accordingly, the heat dissipator 400 may be quickly, stably and accurately attached to the heat source 110 along the vertical direction D1. Moreover, the heat dissipator 400 is avoided from deformation caused by overload or uneven load during an installation process.

Furthermore, the assembly method of the heat dissipation module of this disclosure further has a positioning step (b) and a fixing step (e) described in detail in following paragraphs.

In the positioning step (b), the combination frame 300 further has at least one positioning hole 330, and the fixing seat 200 has at least one positioning pin 220. Before the first assembling step (c) or the second assembling step (d), namely assembling the combination frame 300 and the fixing seat 200 into the semi-assembly or assembling the fixing seat 200 with the semi-assembly, the positioning hole 330 of the combination frame 300 is first fitted with the positioning pin 220 of the fixing seat 200 to position the combination frame 300 on the fixing seat 200, so as to control an assembly accuracy between two parts. In this embodiment, two positioning holes 330 and two positioning pins 220 are provided. Specifically, the positioning holes 330 are disposed opposite to each there at two opposite sides on the combination frame 300, and the positioning pins 220 are also disposed opposite to each other at two opposite sides on the fixing seat 200, but the scopes of this disclosure should not be limited to the embodiment. Accordingly, since the positioning pin 220 and the positioning hole 330 are installed and processed with high accuracies, the combination frame 300 may be effectively and accurately positioned at predetermined positions on the fixing seat 200, so as to ensure that the heat dissipator 400 is sealed with the heat source 110.

In the fixing step (e), a fastening assembly 500 is provided. The fastening assembly 500 has a pressing plate 510 and multiple spring bolts 520. The pressing plate 510 has a pressing portion 511 and a pair of connecting portions 512 connected to two opposite ends of the pressing portion 511. After the second assembling step (d), the spring bolts 520 are respectively inserted through the connecting portions 512 and fastened to the fixing seat 200, so that the heat dissipator 400 is pressed by the pressing portion 511 to attach the heat source 110. Accordingly, the spring bolts 520 are respectively inserted through the connecting portions 512 and then screwed with the fixing seat 200, so that the heat dissipator 400 may be pressed by the pressing portions 511 of the pressing plate 510 to be sealed with the heat source 110 and the heat dissipator 400 may be pressed and firmly fixed to prevent the heat dissipator 400 from deformation caused by overloading or uneven loading.

It should be noted that the circuit board 100, the fixing seat 200, the combination frame 300, the heat dissipator 400 and the fastening assembly 500 have structures the same as structures of the circuit board 100, the fixing seat 200, the combination frame 300, the heat dissipator 400 and the fastening assembly 500 of the heat dissipation module disclosed above, and will not be described in detail herein.

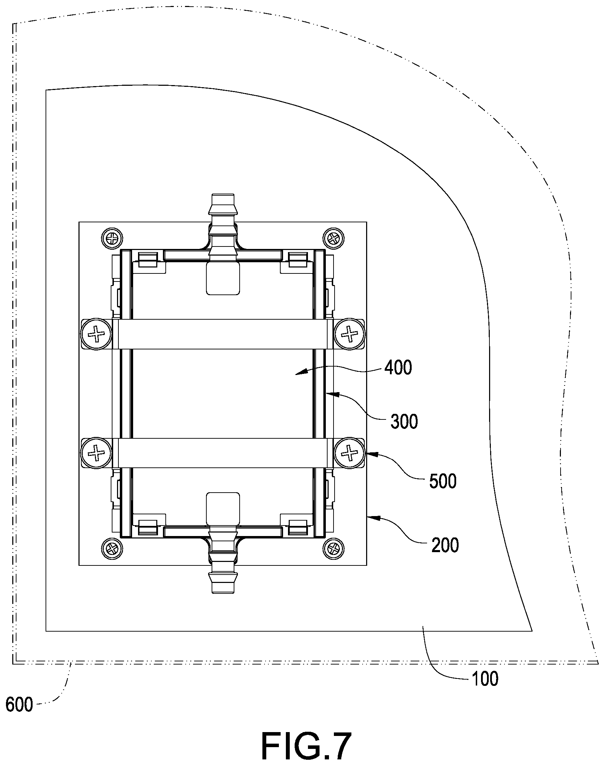

Referring to FIGS. 1 to 5 and 7, this disclosure further provides an electronic device having a housing 600, a circuit board 100, a fixing seat 200, a combination frame 300, and a heat dissipator 400. In this embodiment, the heat dissipator 400 is a liquid cooling head made of metal with good thermal conductivity such as copper or aluminum and it is operated with a cooling liquid, but the scope of this disclosure should not be limited to the embodiment. For example, the heat dissipator 400 may be a heat sink.

The circuit board 100 is arranged in the housing 600. The circuit board 100 has at least one heat source 110. The heat source 110 may be a central processing unit (CPU), a graphics processing unit (GPU), a driver, an electronic element, a power supply or other electronic components, and the scope of this disclosure should not be limited to the embodiment.

The fixing seat 200 is disposed on the circuit board 100 so that the heat source 110 is located at or adjacent to a center of the fixing seat 200. Specifically, the fixing seat 200 in this embodiment is a hollow rectangular plate disposed to surround the heat source 110, but the scopes of this disclosure should not be limited to the embodiment. For example, the fixing seat 200 may be multiple rectangular, curved, or L-shaped blocks or plates which can surround the heat source 110 to locate the heat source 110 at the center or adjacent to the center. Furthermore, the fixing seat 200 in this embodiment is fastened to at least one clamper by a plurality of screws sequentially inserted through the fixing seat 200 and the circuit board 100, so that the fixing seat 200 is firmly fixed on the circuit board 100. Specifically, the clamper may be a metal seat with a plurality of screw holes or a nut, but the scopes of this disclosure should not be limited to the embodiment. The fixing seat 200 has multiple first latches 210. Each first latch 210 is extended from the fixing seat 200 along a vertical direction D1 (i.e. the up-down direction as shown in figures) toward a direction away from the circuit board 100. In this embodiment, the fixing seat 200 is made of metal to ensure a structural strength of a fixing connection to the heat dissipator 400, but the scopes of this disclosure should not be limited to the embodiment.

According to this embodiment, the combination frame 300 is a single-piece plastic part made by injection molding, so that the combination frame 300 is formed as an elastically deformable structure with a required shape, but the scopes of this disclosure should not be limited to the embodiment. The combination frame 300 has a limiting structure 310 and multiple second latches 320. Each of the second latches 320 is extended from the combination frame 300 toward the fixing seat 200 and the circuit board 100. The second latches 320 are respectively snapped on the first latches 210, so as to fix the combination frame 300 on the fixing seat 200. Specifically, according to this embodiment, each of the second latches 320 has a barb 321 at an end thereof, each first latch 210 has a snapping hole 211, so that the barb 321 may be snapped into the snapping hole 211 to perform a snap connection, but the scopes of this disclosure should not be limited to the embodiments. For example, the barb 321 may be arranged on the first latch 210 and the snapping hole 211 may be arranged on the second latch 320, or each of the first latches 210 and the second latches 320 is provided with a barb 321. The heat dissipator 400 is limited by the limiting structure 310, so that at least a portion of the heat dissipator 400 is limited in the combination frame 300. Therefore, the heat dissipator 400 may be limited by the limiting structure 310 of the combination frame 300, and fixed by a connection of respectively snapping the second latches 320 of the combination frame 300 on the first latches 210 of the fixing seat 200. Accordingly, the heat dissipator 400 may be quickly, stably and accurately attached to the heat source 110 along the vertical direction D1. Moreover, the heat dissipator 400 is avoided from deformation caused by overload or uneven load during an installation process.

Furthermore, the combination frame 300 according to this embodiment is a hollow rectangular frame, and the limiting structure 310 of the combination frame 300 has multiple third latches 311 extended therefrom along the vertical direction D1, the third latch 311 are snapped on the heat dissipator 400 together to limit the heat dissipator 400 by the combination frame 300 along the vertical direction D1, but the scopes of this disclosure should not be limited to the embodiment. For example, the combination frame 300 may be a hollow rectangular plate with a recess at a bottom thereof for covering a periphery on a top of the heat dissipator 400, thereby limiting the heat dissipator 400 as well. According to this embodiment, the heat dissipator 400 has multiple snapping notches 410 at four corners on a top thereof, the third latches 311 are respectively snapped on the snapping notches 410, so as to avoid interference caused by the third latches 311 protruding from the heat dissipator 400. Furthermore, the heat dissipator 400 according to this embodiment also has multiple guiding slopes 420 respectively disposed corresponding to the snapping notches 410, the guiding slopes 420 are respectively disposed at four corners on a bottom of the heat dissipator 400, thereby guiding the third latches 311 to avoid stuttering in assembling.

According to this embodiment, the combination frame 300 is rectangular and hollow, and disposed to surround the heat source 110. The heat dissipator 400 is arranged in the combination frame 300, thereby limiting the periphery of the heat dissipator 400 along a longitudinal direction D2 (namely directions forward or backward as shown in figures) and a lateral direction D3(namely directions leftward or rightward as shown in figures) by the combination frame 300. The longitudinal direction D2, the lateral direction D3 and the vertical direction D1 are substantially perpendicular to each other. In other words, the combination frame 300 with a hollow rectangular shape may limit the periphery of the heat dissipator 400, and the third latches 311 are snapped on the heat dissipator 400, so that the heat dissipator 400 may be completely limited. In addition, since the combination frame 300 is snapped into the first latches 210 of the fixing seat 200 via the second latches 320, the heat dissipator 400 may be effectively fixed on the circuit board 100 and prevented from deformation caused by overload.

Furthermore, two positioning holes 330 and two positioning pins 220 are provided, the positioning holes 330 are arranged opposite to each other at two opposite sides of the combination frame 300, and the positioning pins 220 are arranged opposite to each other at two opposite sides of the fixing seat 200, but the scopes of this disclosure should not be limited to the embodiment. The positioning holes 330 of the combination frame 300 respectively sleeve the positioning pins 220 of the fixing seat 200, so as to position the combination frame 300 on the fixing seat 200. It is worth to be mentioned that, the positioning pins 220 and the positioning holes 330 are installed and made accurately, and the combination frame 300 may therefore be effectively positioned at a predetermined position of the fixing seat 200, so that the heat dissipator 400 is sealed with the heat source 110. Furthermore, the fixing seat 200 and the heat dissipator 400 of this embodiment are both made of metal, and the combination frame 300 is made of plastic, so that the combination frame 300 has a structural strength lower than that of the fixing seat 200 and the heat dissipator 400, and the combination frame 300 is therefore elastically deformable. When the combination frame 300 is snapped to the first latches 210 of the fixing seat 200 through the second latches 320, a slight elastic deformation may be caused on the combination frame 300 to eliminate dimensional tolerances between the heat dissipator 400, the combination frame 300, and the fixing seat 200, so that the combination frame 300 may be accurately fixed on the fixing seat 200 together with the heat dissipator 400.

In order to further ensure the stability of the heat dissipator 400, the heat dissipation module of this disclosure further has a fastening assembly 500. The fastening assembly 500 has at least one pressing plate 510 and multiple spring bolts 520. In this embodiment, two the pressing plates 510 and four the spring bolts 520 are provided, but the scopes of this disclosure should not be limited to the embodiment. For example, only one pressing plate 510 or more than three pressing plates 510 may be provided, and a specific quantity of the spring bolt(s) 520 may be provided corresponding to quantity and form of the pressing plate(s) 510. Each of the pressing plates 510 has a pressing portion 511 and a pair of connecting portions 512 respectively connected to two opposite ends of the pressing portion 511. Specifically, each pressing portion 511 is a plate adapted to attach on a top of the heat dissipator 400, the connecting portions 512 are respectively connected to the two opposite ends of the pressing portion 511 and therefore located at two opposite sides of the heat dissipator 400. The spring bolts 520 are respectively inserted in the connecting portions 512 and screwed to the fixing seat 200, so that the heat dissipator 400 is pressed by the pressing portion 511 to attach on the heat source 110. According to this embodiment, the fixing seat 200 has multiple studs 230, the spring bolts 520 are respectively inserted through the connecting portions 512 and further screwed with the studs 230, but the scopes of this disclosure should not be limited to the embodiment. Accordingly, the spring bolts 520 are respectively inserted through the connecting portions 512 and then screwed with the fixing seat 200, so that the heat dissipator 400 may be pressed by the pressing portions 511 of the pressing plate 510 to be sealed with the heat source 110 and the heat dissipator 400 may be pressed and firmly fixed to prevent the heat dissipator 400 from deformation caused by overloading or uneven loading.

According to the heat dissipation module and the electronic device of this disclosure, the first latches 210 of the fixing seat 200 are respectively snapped on the second latches 320 of the combination frame 300, and the heat dissipator 400 may be limited by the limiting structure 310 of the combination frame 300. Accordingly, the heat dissipator 400 may be quickly, stably and accurately attached to the heat source 110. Moreover, the heat dissipator 400 is avoided from deformation caused by overload or uneven load during an installation process.

## Claims

1. A heat dissipation module, for cooling a heat source (110) on a circuit board (100), the heat dissipation module comprising:
a fixing seat (200), arranged on the circuit board (100) to locate the heat source (110) at or adjacent to a center of the fixing seat (200), the fixing seat (200) comprising a plurality of first latches (210);
a combination frame (300), comprising a limiting structure (310) and a plurality of second latches (320), the second latches (320) snapped on the first latches (210) respectively to fix the combination frame (300) on the fixing seat (200); and
a heat dissipator (400), limited by the limiting structure (310), at least a portion of the heat dissipator (400) is limited in the combination frame (300) so that the heat dissipator (400) is attached to the heat source (110) along a vertical direction (D1).

2. The heat dissipation module according to claim 1, wherein the limiting structure (310) comprises a plurality of third latches (311), the third latches (311) are snapped on the heat dissipator (400) to gather so that the heat dissipator (400) is limited by the combination frame (300) along the vertical direction (D1).

3. The heat dissipation module according to claim 1, wherein the combination frame (300) is rectangular and hollow and disposed to surround the heat source (110), the heat dissipator (400) is arranged in the combination frame (300) so that the heat dissipator (400) is limited by the combination frame (300) along a longitudinal direction (D2) and a lateral direction (D3), the longitudinal direction (D2), the lateral direction (D3) and the vertical direction (D1) are perpendicular to each other.

4. The heat dissipation module according to claim 1, wherein the combination frame (300) comprises a positioning hole (330), the fixing seat (200) comprises a positioning pin (220), the positioning hole (330) sheathes the positioning pin (220) to position the combination frame (300) on the fixing seat (200).

5. The heat dissipation module according to claim 1, further comprising a fastening assembly (500), the fastening assembly (500) comprising a pressing plate (510) and a plurality of spring bolts (520), the pressing plate (510) comprising a pressing portion (511) and a pair of connecting portions (512) respectively connected to two opposite end of the pressing portion (511), the fixing seat (200) comprising a plurality of studs (230), the spring bolts (520) respectively penetrating through the connecting portions (512) to respectively fasten the studs (230) so that the heat dissipator (400) is pressed by the pressing portion (511) to attach on the heat source (110).

6. An assembling method of a heat dissipation module, comprising:
a pre-assembling step (a), comprising providing a circuit board (100) and a fixing seat (200), the circuit board (100) comprising a heat source (110), the fixing seat (200) comprising a plurality of first latches (210), arranging the fixing seat (200) on the circuit board (100) to locate the heat source (110) at or adjacent to a center of the fixing seat (200);
a first assembling step (c), comprising providing a combination frame (300) and a heat dissipator (400), the combination frame (300) comprising a limiting structure (310) and a plurality of second latches (320), assembling the combination frame (300) with one of the fixing seat (200) and the heat dissipator (400) into a semi-assembly; and
a second assembling step (d), comprising assembling another of the fixing seat (200) and the heat dissipator (400) with the semi-assembly, respectively snapping the second latches (320) on the first latches (210) to fix the combination frame (300) on the fixing seat (200), and meanwhile limiting at least a portion of the heat dissipator (400) by the limiting structure (310) to attach the heat dissipator (400) on the heat source (110).

7. The assembling method according to claim 6, further comprising a fixing step (e), the fixing step (e) comprising providing a pressing plate (510) and a plurality of spring bolts (520), the pressing plate (510) comprising a pressing portion (511) and a pair of connecting portions (512) respectively connected to two opposite ends of the pressing portion (511), respectively penetrating the spring bolts (520) to the connecting portions (512) to fasten to the fixing seat (200) so that the heat dissipator (400) is pressed by the pressing portion (511) to attach on the heat source (110).

8. An electronic device, comprising:
a housing (600);
a circuit board (100), arranged in the housing (600), the circuit board (100) comprising a heat source (110);
a fixing seat (200), arranged on the circuit board (100) to locate the heat source (110) at or adjacent to a center of the fixing seat (200), the fixing seat (200) comprising a first latch (210);
a combination frame (300), comprising a limiting structure (310) and a plurality of second latches (320), and the second latches (320) respectively snapping on the first latches (210) to fix the combination frame (300) on the fixing seat (200); and
a heat dissipator (400), limited by the limiting structure (310), at least a portion of the heat dissipator (400) limited in the combination frame (300) so that the heat dissipator (400) is attached to the heat source (110) along a vertical direction (D1).

9. The electronic device according to claim 8, wherein the limiting structure (310) comprises a plurality of third latches (311), the third latches (311) are snapped on the heat dissipator (400) to gather so that the heat dissipator (400) is limited by the combination frame (300) along the vertical direction (D1).

10. The electronic device according to claim 8, wherein the combination frame (300) is rectangular and hollow and disposed to surround the heat source (110), the heat dissipator (400) is arranged in the combination frame (300) so that the heat dissipator (400) is limited by the combination frame (300) along a longitudinal direction (D2) and a lateral direction (D3), the longitudinal direction (D2), the lateral direction (D3) and the vertical direction (D1) are perpendicular to each other.

11. The electronic device according to claim 8, wherein the combination frame (300) comprises a positioning hole (330), the fixing seat (200) comprises a positioning pin (220), the positioning hole (330) sheathes the positioning pin (220) to position the combination frame (300) on the fixing seat (200).

12. The electronic device according to claim 8, further comprising a fastening assembly (500), the fastening assembly (500) comprising a pressing plate (510) and a plurality of spring bolts (520), the pressing plate (510) comprising a pressing portion (511) and a pair of connecting portions (512) respectively connected to two opposite end of the pressing portion (511), the fixing seat (200) comprising a plurality of studs (230), the spring bolts (520) respectively penetrating through the connecting portions (512) to respectively fasten the studs (230) so that the heat dissipator (400) is pressed by the pressing portion (511) to attach on the heat source (110).

## Amended claims

### Amended claims in accordance with Rule 137(2) EPC.

1. A heat dissipation module, for cooling a heat source (110) on a circuit board (100), the heat dissipation module comprising:
a fixing seat (200), arranged on the circuit board (100) to locate the heat source (110) at or adjacent to a center of the fixing seat (200), the fixing seat (200) comprising a plurality of first latches (210);
a combination frame (300), being hollow and rectangular and comprising a limiting structure (310) and a plurality of second latches (320), and the second latches (320) respectively snapping on the first latches (210) to fix the combination frame (300) on the fixing seat (200); and
a heat dissipator (400), a periphery of the heat dissipator (400) limited in the combination frame (300);
wherein the limiting structure (310) comprises a plurality of third latches (311), the third latches (311) are snapped on the heat dissipator (400) together so that the heat dissipator (400) is limited by the combination frame (300) along a vertical direction (D1) and attached to the heat source (110) along the vertical direction (D1).

2. The heat dissipation module according to claim 1, wherein the combination frame (300) is disposed to surround the heat source (110), the heat dissipator (400) is arranged in the combination frame (300) so that the heat dissipator (400) is limited by the combination frame (300) along a longitudinal direction (D2) and a lateral direction (D3), the longitudinal direction (D2), the lateral direction (D3) and the vertical direction (D1) are perpendicular to each other.

3. The heat dissipation module according to claim 1, wherein the combination frame (300) comprises a positioning hole (330), the fixing seat (200) comprises a positioning pin (220), the positioning hole (330) sheathes the positioning pin (220) to position the combination frame (300) on the fixing seat (200).

4. The heat dissipation module according to claim 1, further comprising a fastening assembly (500), the fastening assembly (500) comprising a pressing plate (510) and a plurality of spring bolts (520), the pressing plate (510) comprising a pressing portion (511) and a pair of connecting portions (512) respectively connected to two opposite end of the pressing portion (511), the fixing seat (200) comprising a plurality of studs (230), the spring bolts (520) respectively penetrating through the connecting portions (512) to respectively fasten the studs (230) so that the heat dissipator (400) is pressed by the pressing portion (511) to attach on the heat source (110).

5. An assembling method of a heat dissipation module, comprising:
A pre-assembling step (a), comprising providing a circuit board (100) and a fixing seat (200), the circuit board (100) comprising a heat source (110), the fixing seat (200) comprising a plurality of first latches (210), arranging the fixing seat (200) on the circuit board (100) to locate the heat source (110) at or adjacent to a center of the fixing seat (200);
a first assembling step (c), comprising providing a combination frame (300) and a heat dissipator (400), the combination frame (300) being hollow and rectangular and comprising a limiting structure (310) and a plurality of second latches (320), the limiting structure (310) comprising a plurality of third latches (311), assembling the combination frame (300) with one of the fixing seat (200) and the heat dissipator (400) into a semi-assembly; and
a second assembling step (d), comprising assembling another of the fixing seat (200) and the heat dissipator (400) with the semi-assembly, respectively snapping the second latches (320) on the first latches (210) to fix the combination frame (300) on the fixing seat (200), meanwhile limiting periphery of the heat dissipator (400) by the limiting structure (310), and snapping the third latches (311) on the heat dissipator (400) together so that the heat dissipator (400) is limited by the combination frame (300) along a vertical direction (D1) and attached to the heat source (110) along the vertical direction (D1).

6. The assembling method according to claim 5, further comprising a fixing step (e), the fixing step (e) comprising providing a pressing plate (510) and a plurality of spring bolts (520), the pressing plate (510) comprising a pressing portion (511) and a pair of connecting portions (512) respectively connected to two opposite ends of the pressing portion (511), respectively penetrating the spring bolts (520) to the connecting portions (512) to fasten to the fixing seat (200) so that the heat dissipator (400) is pressed by the pressing portion (511) to attach on the heat source (110).

7. An electronic device, comprising:
a c housing (600);
a circuit board (100), arranged in the housing (600), the circuit board (100) comprising a heat source (110);
a fixing seat (200), arranged on the circuit board (100) to locate the heat source (110) at or adjacent to a center of the fixing seat (200), the fixing seat (200) comprising a plurality of first latches (210);
a combination frame (300), being hollow and rectangular and comprising a limiting structure (310, and a plurality of second latches (320), and the second latches (320) respectively snapping on the first latches (210) to fix the combination frame (300) on the fixing seat (200); and
a heat dissipator (400), a periphery of the heat dissipator (400) limited in the combination frame (300);
wherein the limiting structure (310) comprises a plurality of third latches (311), the third latches (311) are snapped on the heat dissipator (400) together so that the heat dissipator (400) is limited by the combination frame (300) along a vertical direction (D1) and attached to the heat source (110) along the vertical direction (D1).

8. The electronic device according to claim 7, wherein the combination frame (300) is disposed to surround the heat source (110), the heat dissipator (400) is arranged in the combination frame (300) so that the heat dissipator (400) is limited by the combination frame (300) along a longitudinal direction (D2) and a lateral direction (D3), the longitudinal direction (D2), the lateral direction (D3) and the vertical direction (D1) are perpendicular to each other.

9. The electronic device according to claim 7, wherein the combination frame (300) comprises a positioning hole (330), the fixing seat (200) comprises a positioning pin (220), the positioning hole (330) sheathes the positioning pin (220) to position the combination frame (300) on the fixing seat (200).

10. The electronic device according to claim 7, further comprising a fastening assembly (500), the fastening assembly (500) comprising a pressing plate (510) and a plurality of spring bolts (520), the pressing plate (510) comprising a pressing portion (511) and a pair of connecting portions (512) respectively connected to two opposite end of the pressing portion (511), the fixing seat (200) comprising a plurality of studs (230), the spring bolts (520) respectively penetrating through the connecting portions (512) to respectively fasten the studs (230) so that the heat dissipator (400) is pressed by the pressing portion (511) to attach on the heat source (110).
